Europäisches Patentamt

European Patent Office

Office européen des brevets

(19)

(11) **EP 0 971 478 B1**

(12) **FASCICULE DE BREVET EUROPEEN**

(45) Date de publication et mention
de la délivrance du brevet:
**02.05.2001 Bulletin 2001/18**

(51) Int Cl.⁷: **H03F 1/32**

(21) Numéro de dépôt: **99401731.7**

(22) Date de dépôt: **09.07.1999**

(54) **Dispositif d'amplification de répéteur de système de radiocommunication cellulaire et procédé pour sa mise en oeuvre**

Zwischenverstärkervorrichtung in einem zellularen Funkkommunikationssystem und Verfahren zu ihrem Betrieb

Repeater amplification device in a cellular radio communication system and method of operation thereof

(84) Etats contractants désignés:
**DE ES FR GB IT**

(30) Priorité: **10.07.1998 FR 9808947**

(43) Date de publication de la demande:
**12.01.2000 Bulletin 2000/02**

(73) Titulaire: **FRANCE TELECOM**
**75015 Paris (FR)**

(72) Inventeur: **Veyres, Camille**
**75116 Paris (FR)**

(74) Mandataire: **Ballot, Paul**
**Cabinet Ballot**
**7, rue Le Sueur**
**75116 Paris (FR)**

(56) Documents cités:
**EP-A- 0 678 976         WO-A-94/17587**
**US-A- 5 077 532**

# Description

La présente invention se rapporte à un dispositif d'amplification pour répéteur de système de radiocommunication cellulaire et à un procédé pour sa mise en oeuvre. Elle s'applique notamment à un système GSM 900, mais peut également s'appliquer à d'autres systèmes de radiocommunication, notamment un système DCS 1800.

Dans la suite, et à moins qu'il n'en soit disposé autrement, on considère l'exemple non limitatif d'un système de radiocommunication de type GSM 900. Les initiales GSM sont mises pour "Global System for Mobiles", ce qui, en anglais, signifie "Système Global pour les Mobiles".

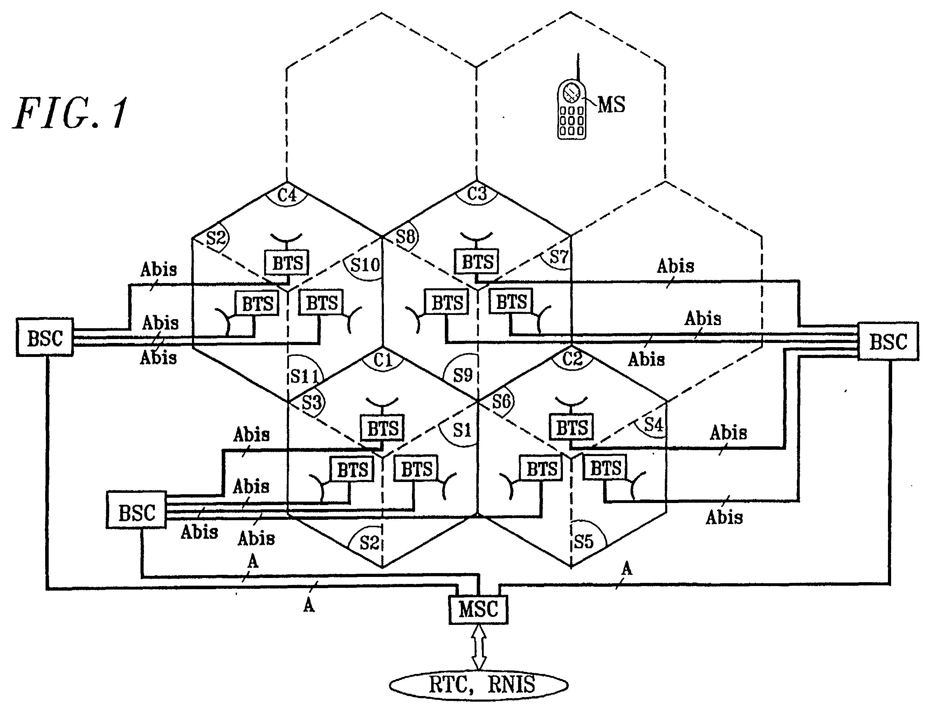

Un tel système (figure 1) comprend des stations mobiles et des moyens de communication fixes.

Les stations mobiles sont les équipements physiques utilisés par les usagers du système. Il s'agit notamment des appareils notés MS à la figure 1 et qui peuvent être des stations montées en véhicule, des stations portables, ou des téléphones portatifs.

Les moyens de communication fixes comprennent des stations de base (Base Transmitter Station, en anglais) ci-après appelées BTS, pour échanger (émission et réception) des signaux de parole ou de données avec les stations mobiles.

Plus exactement, les BTS assurent une fonction de modulation/démodulation de porteuses radioélectriques par ces signaux de parole ou de donnée, et une fonction de transposition et de multiplexage/démultiplexage de ces porteuses radioélectriques dans la bande allouée à l'opérateur.

A cet effet, chaque BTS comprend des moyens matériels et logiciels permettant l'échange de signaux radioélectriques avec les stations mobiles se trouvant dans sa zone de couverture, dans chacun des deux sens possibles.

Notamment, chaque BTS comprend des émetteurs/récepteurs en nombre égal au nombre de porteuses radioélectriques utilisées par la BTS. Dans la terminologie des systèmes GSM 900 et dans la suite, ces équipements sont appelés TRX.

De plus, chaque BTS est reliée à au moins une antenne réalisant l'interface avec l'air. En outre, des équipements fixes d'émission/réception radioélectrique assurent l'amplification de puissance et le couplage aux antennes pour la transmission des porteuses modulées. Dans la suite, ces équipements sont appelés relais.

La zone de couverture d'une BTS, c'est-à-dire la zone géographique dans laquelle les communications avec les stations mobiles sont transmises par l'intermédiaire de cette BTS, est appelée zone de BTS ou secteur. L'aire géographique couverte par le système de radiocommunication est ainsi segmentée en un réseau de secteurs, dit aussi "réseau mobile".

Les moyens de communication fixes du système comprennent aussi des contrôleurs de stations de base (Base Stations Controller, en anglais), ci-après appelés BSC, assurant une fonction de commande et de contrôle des BTS. Chaque BTS est reliée à un BSC. Chaque BSC peut être relié à une ou plusieurs BTS pour les commander et les contrôler.

Les moyens de communication fixes comportent enfin des commutateurs de services mobiles (Mobiles Services Commutator, en anglais), ci-après appelés MSC, assurant toutes les fonctions de commutation nécessaires pour les stations mobiles situés dans une partie, appelée zone de MSC, de la zone géographique couverte par le système. Dit autrement, un MSC est un autocommutateur de téléphonie. Il est relié à un ou des réseaux de télécommunication fixes, tels que le réseau téléphonique commuté (RTC) conçu pour le transport de la parole, ou le réseau numérique d'intégration de service (RNIS) conçu pour le transfert de la parole et de données. Il assure et met à jour la localisation des stations mobiles et applique les procédures prévues pour l'acheminement des communications en prenant en compte la nature mobile des usagers.

L'interface entre un MSC et un BSC est appelée interface A et l'interface entre un BSC et une BTS est appelée interface Abis. Ce sont des liaisons filaires (paires torsadées en cuivre) supportant un débit numérique de l'ordre de 2 Mbits/s (mégabits par seconde). Ces interfaces sont normalisées de manière à permettre l'assemblage d'équipements de diverses origines.

Selon les prescriptions de la norme GSM 05-05 un système ne peut utiliser que des porteuses se situant dans une première bande de fréquences comprise entre 890 et 915 MHz mégahertzs) pour le sens réseau mobile vers réseau fixe (appelé voie montante) et dans une seconde bande de fréquence comprise entre 935 et 960 MHz pour le sens réseau fixe vers réseau mobile (appelé voie descendante).

Dans chacune de ces deux bandes, les systèmes ne peuvent en fait utiliser que 124 porteuses monofréquences déterminées, espacées avec un pas de 200 KHz (kilohertzs). Dans une aire géographique déterminée, l'usage exclusif de telle ou telle porteuse par tel ou tel système est réglementé par l'administration publique. Bien entendu, si plusieurs systèmes gérés par des opérateurs différents coexistent dans une même aire géographique, chaque opérateur veille à n'émettre que sur celles des 124 porteuses qui lui sont réservées, de manière à ne pas perturber les porteuses réservées à ses concurrents.

Une porteuse de la première bande et une porteuse de la seconde bande sont associées pour constituer un circuit téléphonique bidirectionnel. L'écart entre ces deux porteuses est appelé écart duplex. Cet écart est constant. Pour un système de type GSM 900, il vaut 45 MHz.

En raison du nombre limité de circuits téléphoniques bidirectionnels ainsi disponibles, chaque opérateur utilise en fait une même porteuse dans plusieurs secteurs suffisamment éloignés les uns des autres pour éviter tout risque d'interférences entre les circuits téléphoniques correspondants.

Plus précisément, un groupe de plusieurs porteuses de la première bande (et leurs porteuses associées de la seconde bande) sont affectées à un groupe de plusieurs BTS dont les secteurs sont géographiquement non contigus.

Par exemple, dans le système de l'opérateur FRANCE TELECOM, auquel sont réservées soixante deux porteuses dans chaque bande (soit un spectre de 12 MHz de largeur) les porteuses sont réparties en douze groupes de cinq porteuses (deux porteuses n'étant pas utilisées). Dans la suite, on utilisera l'expression "couleur" pour désigner un tel groupe de porteuses. Ces douze couleurs sont respectivement affectées à douze secteurs géographiquement contigus.

A la figure 1, on a représenté schématiquement les moyens essentiels d'un système de radiocommunication cellulaire selon l'art antérieur.

Trois BTS, dont les secteurs S1, S2 et S3 sont adjacents, sont regroupées sur un même site appelé base, et sont reliées respectivement à trois antennes directives orientées selon des directions à 120° l'une de l'autre. Ces trois secteurs forment une cellule C1. De même trois autres cellules C2, C3 et C4 sont formées chacune de trois secteurs couvrant chacun un angle de 120°, respectivement S4-S6, S7-S9, et S10-S12. On parle de cellules tri-sectorielles. A centre de chaque cellule se trouve une base abritant les BTS des trois secteurs de la cellule.

Une cellule est communément représentée de façon stylisée par un hexagone, ainsi qu'on peut le voir à la figure 1.

L'aire géographique couverte par le système de radiocommunication est donc segmentée en un réseau de cellules tri-sectorielles, avec un plan d'attribution des fréquences constitué par un motif de base à quatre cellules et douze couleurs reproduit autant de fois que nécessaire, par abus de langage, les termes "secteur" et "cellule" seront indistinctement utilisés dans la suite pour désigner une zone de BTS.

Une BTS donnée utilise donc les fréquences d'une seule et unique couleur pour les communications avec les mobiles présents dans la cellule à laquelle elle est associée. Les BTS comprennent donc autant de TRX qu'il y a de porteuses dans la couleur. Dans l'exemple ci-dessus, les BTS comprennent cinq TRX.

En outre, l'axe des temps est divisé en intervalles de temps réguliers (Time Slots, en anglais), ci-après appelés IT, dont la durée est égale à 0,577 ms. Huit tels intervalles consécutifs forment une trame. Une trame dure donc 4,6 ms. Au sein d'une trame, les IT sont repérés par un numéro de zéro à sept. Une régulation du niveau des porteuses est prévue de manière que les porteuses de conversation peuvent changer de niveau à chaque IT. La suite récurrente des IT portant le même numéro constitue un canal physique pour la transmission de données ou de la parole. En moyenne, seuls sept IT par trame sont disponibles pour la transmission des conversations. C'est donc sept canaux physiques qui sont disponibles par porteuse.

Bien évidemment, cette division de l'axe des temps en intervalles s'applique aussi bien à la voie montante qu'à la voie descendante. Cependant la numérotation des IT pour la voie montante et la numérotation des IT pour la voie descendante sont décalées de trois unités. De la sorte, on s'assure qu'une station mobile ne peut émettre et recevoir en même temps.

On constate ainsi un double entrelacement temporel et fréquentiel des canaux physiques pour la voie montante et des canaux physiques associés pour la voie descendante.

De plus, la plupart des systèmes de radiocommunication GSM 900 utilisent la possibilité, prévue par la norme GSM, d'un saut de fréquence lent. Comme on le sait, cette fonctionnalité consiste à modifier de façon périodique (à chaque trame, soit toutes les 4,6 ms) l'attribution des couleurs aux différents secteurs du motif de base du réseau mobile. Ce saut de fréquence permet de répartir entre plusieurs canaux physiques l'effet d'un éventuel brouilleur qui perturberait une fréquence déterminée. Cette répartition se traduit par une homogénéisation du rapport signal/bruit des différents canaux physiques et, par conséquent, par une amélioration de la qualité globale des radiocommunications.

Dans chaque IT, on émet un train de 148 bits comprenant 114 bits d'informations utiles. Les bits restant sont des bits de service, notamment de signalisation et de synchronisation. Les bits de service comprennent notamment une séquence de 26 bits disposée en milieu de train, dite "séquence d'apprentissage", choisie pour ses bonnes propriétés d'autocorrélation. Cette séquence a pour fonction de permettre la synchronisation du canal physique malgré les phénomènes de trajets multiples inhérente à toute propagation radio-électrique.

Différents types de canaux logiques sont multiplexés sur les canaux physiques. En effet, ces canaux logiques sont de deux types: d'une part des canaux de trafic (Trafic Channel, en anglais), ci-après appelés canaux TCH, et d'autre part des canaux de contrôle ou de signalisation (Control Channel, en anglais), ci-après appelés canaux CCH.

Les premiers servent à la transmission de la parole ou de données produites par les usagers (les porteuses qui supportent les canaux TCH sont parfois appelées porteuses de conversation ou porteuses de trafic).

Les seconds servent à la transmission d'informations nécessaires à la gestion du système. Notamment, les canaux CCH comprennent un canal diffusé (Broadcast Control Channel, en anglais), ci-après canal BCCH, qui fournit aux stations mobiles des informations relatives à la cellule dans laquelle elles se trouvent ainsi qu'aux cellules voisines. Le canal BCCH est un canal dans le sens réseau fixe vers réseau mobile. La porteuse qui supporte ce canal, dite ci-après "porteuse $F_{BCCH}$" ou "porteuse balise", est émise à fréquence constante et sans régulation de niveau (en fait, elle est émise à la puissance maximum autorisée dans la cellule).

Une porteuse $F_{BCCH}$ est associée à chaque secteur du motif de base. Un réseau mobile à motif de base à n secteurs nécessite donc au moins n porteuses $F_{BCCH}$. De plus, les porteuses $F_{BCCH}$ ne sont pas soumises au saut lent de fréquence.

Chaque station mobile comporte des moyens pour mesurer le niveau de toutes les porteuses $F_{BCCH}$ qu'il lui est imposé de mesurer, à savoir la porteuse $F_{BCCH}$ associée à la cellule dans laquelle il se trouve, et les porteuses $F_{BCCH}$ associées aux cellules adjacentes à cette cellule. Les stations mobiles comportent aussi des moyens pour envoyer un rapport de mesure après calcul d'une moyenne sur un certain nombre de mesures, ce rapport incluant des informations sur la qualité des informations reçues en vue de permettre le basculement intercellulaire (hand-over, en anglais) nécessité par la nature mobile des usagers. La qualité des informations reçues est déterminée par le calcul d'un taux d'erreur.

L'invention concerne un dispositif d'amplification pour répéteur de système de radiocommunication cellulaire tel que celui décrit ci-dessus. Plus particulièrement, le répéteur est un répéteur placé dans la chaîne de transmission descendante (réseau fixe vers réseau mobile). C'est pourquoi, notamment, on n'évoquera que le traitement des porteuses de la seconde bande définie ci-dessus (935-960 MHz).

Un tel répéteur est par exemple placé dans le système en aval des BTS, le terme aval devant ici être compris en considérant le sens réseau fixe vers réseau mobile.

Un amplificateur tel que celui auquel se rapporte l'invention doit amplifier un signal multiporteuses, c'est-à-dire ayant un spectre contenant une pluralité de fréquences utiles réparties dans une certaine bande, dite ci-après bande utile. Comme on l'aura compris, ces fréquences sont celles de porteuses GSM multiplexées, comprises dans la bande allouée à un opérateur ou dans une partie de celle-ci uniquement. Ces fréquences étant discrètes (espacées de 200 kHz au moins), on parlera d'un spectre discret.

Un tel amplificateur introduit des perturbations non linéaires à l'intérieur de la bande utile, impliquant une modification du spectre du signal.

Cette modification est due à l'apparition de fréquences parasites (ou battements d'intermodulation) résultant des produits d'intermodulation entre les fréquences utiles du spectre.

La présence de ces fréquences parasites conduit à des consommations électriques et à des dissipations thermiques qui peuvent être incompatibles avec la nature compacte et/ou téléalimentée des répéteurs. Un dispositif de linéarisation de l'amplificateur est donc nécessaire. Un tel dispositif a pour fonction d'éliminer ou du moins d'atténuer très fortement le niveau des fréquences parasites.

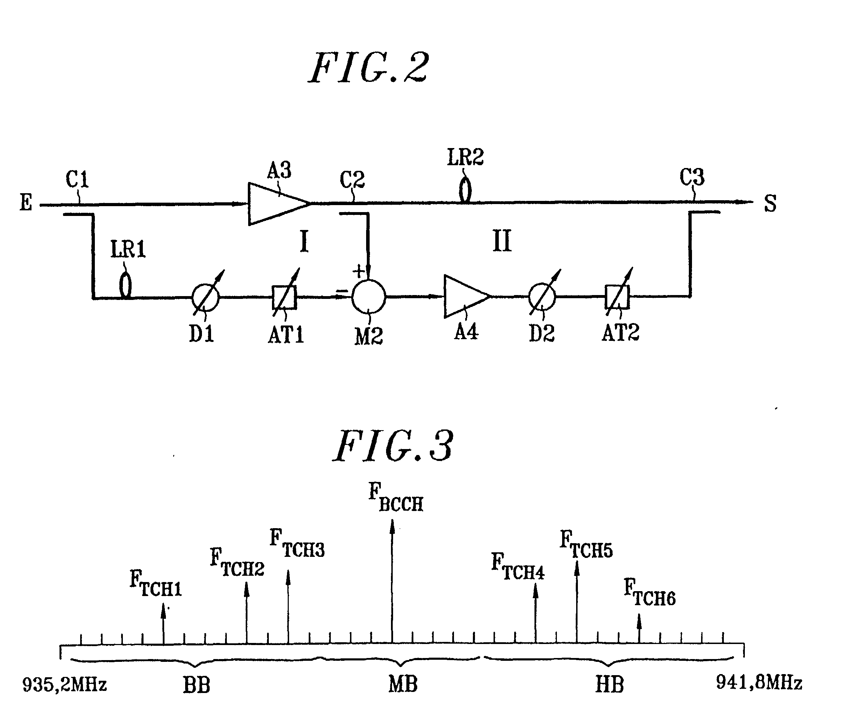

Dans l'état de la technique, on a déjà proposé des dispositifs remplissant une telle fonction de linéarisation. Ainsi, on connaît depuis longtemps le principe de l'amplificateur à contre réaction aval (feed-forward, en anglais) exposé ci-dessous en référence à la figure 2.

Le circuit d'un amplificateur à contre réaction aval représenté à la figure 2 comprend une première et une seconde boucles respectivement notées I et II.

La boucle I, dite aussi boucle amont, comporte un amplificateur de puissance A3, dit amplificateur principal. Le signal multiplexé à amplifier est porté sur l'entrée E du circuit à laquelle l'entrée de l'amplificateur A3 est reliée. La sortie de l'amplificateur A3 est reliée à la sortie S du circuit.

La boucle II, dite aussi boucle aval, comporte un amplificateur A4, dit amplificateur auxiliaire. Cet amplificateur auxiliaire n'amplifie que les fréquences parasites résultant des produits d'intermodulation des porteuses comprises dans la bande utile du signal à amplifier. A cet effet un coupleur M2 fonctionnant en soustracteur produit, par interférométrie, la différence entre le signal amplifié (prélevé par un coupleur C2 disposé immédiatement en aval de l'amplificateur A3) d'une part, et le signal à amplifier (prélevé par un coupleur C1 disposé immédiatement en amont de l'amplificateur A3) d'autre part. Le signal présent en sortie du coupleur M2 contient essentiellement les fréquences parasites et également des résidus du signal porté sur l'entrée E. Il est porté en entrée de l'amplificateur A4.

Un déphaseur variable Dl et un atténuateur variable AT1 disposés en série, dans la boucle amont I entre la sortie du coupleur C1 et l'entrée négative du mélangeur M2 permettent d'assurer le réglage de cette boucle.

Le signal en sortie de l'amplificateur A4 est injecté au moyen d'un coupleur C3 dans le signal amplifié délivré par l'amplicateur A3, en opposition de phase et au niveau requis pour assurer l'annulation par interférométrie des fréquences parasites dans le signal amplifié. Le coupleur C3 est disposé en aval du coupleur C2. La sortie du coupleur C3 est reliée à la sortie S de l'amplificateur.

En outre, un déphaseur variable D2 et un atténuateur variable AT2 disposés en série entre la sortie de l'amplificateur A4 et l'entrée du coupleur C3 permettent d'assurer le réglage de la boucle aval II.

De plus, une ligne à retard LR1 est insérée dans la boucle amont I entre le coupleur C1 et le déphaseur variable D1 permet de compenser le retard introduit par l'amplificateur A3. De même, une ligne à retard LR2 est insérée dans la boule aval II entre les coupleurs C2 et C3 pour compenser le retard introduit par l'amplificateur A4.

Dit autrement, la boucle amont I supprime par interférométrie les composantes du signal amplifié correspondant aux fréquences utiles et délivre un signal ne contenant que les fréquences parasites introduites par la non linéarité de l'amplificateur principal. La boucle aval II, quant à elle, amplifie ledit signal délivré par la boucle amont I et le réinjecte avec le bon niveau et avec la bonne phase de façon à annuler, par interférométrie, les composantes correspondant aux fréquences parasites dans le signal délivré en sortie S de l'amplificateur.

Un amplificateur tel que ci-dessus requiert un réglage. Ce réglage a pour but de déterminer la commande adéquate du déphaseur variable et de l'atténuateur variable de chacune des boucles amont et aval, à savoir respectivement D1 et AT1, et D2 et AT2.

Le réglage est en pratique effectué pour une fréquence déterminée, dite fréquence pilote, et on considère qu'il est valable pour l'ensemble des fréquences de la bande utile. Dans l'état de la technique, ceci est réalisé de la manière suivante.

Un signal à cette fréquence pilote, dit en l'occurrence signal d'erreur pilote, est introduit dans le signal amplifié. Ce signal est injecté à la sortie de l'amplificateur principal. Il s'agit par exemple d'une porteuse à bande très étroite, modulée à la fréquence du hertz par une suite de bits présentant de bonnes propriétés d'autocorrélation. De cette façon, on peut ensuite mesurer ce signal avec une bonne sensibilité, même si il est en partie masqué par les fréquences parasites.

Le dispositif comporte donc des moyens de réglage qui sont pilotés par des observations (c'est-à-dire des mesures) à la fréquence pilote. On dit aussi que ces moyens sont pilotés à cette fréquence.

Dans les dispositifs connus, la fréquence pilote est située à l'extérieur de la bande utile pour ne pas perturber les fréquences utiles du signal.

Cette caractéristique est néanmoins difficilement concevable dans un système GSM dans la mesure où il convient aussi de ne pas perturber les fréquences comprises à l'extérieur de la bande utile, ces fréquences étant des fréquences de porteuses simultanément utilisées par d'autres systèmes.

En outre, l'introduction d'un signal pilote ou d'un signal d'erreur pilote augmente la complexité et donc le coût du dispositif.

C'est un objet de la présente invention que de proposer un dispositif d'amplification pour répéteur de système de radiocommunication cellulaire, notamment un système conforme à la norme GSM 900 ou à la norme DCS 1800 qui ne présente pas les inconvénients précités des dispositifs d'amplification de l'art antérieur.

A cet effet, l'invention propose un dispositif d'amplification du type précité, destiné à l'amplification d'un signal multiporteuses ayant un spectre discret qui comprend une porteuse balise dont la fréquence est fixe et est associée à la cellule dans laquelle se trouve le répéteur, et au moins une porteuse de trafic soumise à un saut lent de fréquence, ce dispositif étant remarquable en ce qu'il comporte :

- un amplificateur principal;

- un dispositif à contre réaction aval comprenant une boucle amont pour extraire par interférométrie les composantes du signal amplifié qui correspondent à des fréquences parasites, et une boucle aval pour annuler par interférométrie lesdites composantes dans le signal amplifié;

- des moyens de réglage de la boucle amont qui sont pilotés à la fréquence de la porteuse balise.

Ainsi, le signal pilote utilisé pour le réglage de cette boucle est déjà contenu dans le signal à amplifier. Aucun signal pilote ou signal d'erreur pilote n'a besoin d'être introduit ni à l'intérieur ni à l'extérieur de la bande utile. On profite donc de ce que le spectre du signal à amplifier comporte naturellement une porteuse de fréquence déterminée connue, en l'occurrence la porteuse balise.

On a vu plus haut que les porteuses balises ne sont pas soumises au saut de fréquence comme c'est le cas des porteuses de trafic. Il est donc particulièrement avantageux d'utiliser la fréquence d'une porteuse balise comme fréquence pilote, et non une fréquence d'une porteuse de trafic qui peut être considérée comme une fréquence dont la valeur varie aléatoirement dans le temps.

En outre, on dispose déjà, à de bonnes conditions économiques, de moyens de mesure du niveau de tension des signaux aux fréquences des porteuses balises. En effet, de tels moyens sont déjà compris dans les stations mobiles du système. Ces moyens sont fiables et éprouvés. On les fabrique déjà industriellement.

D'autres caractéristiques et avantages de la présente invention apparaîtront encore à la lecture de la description qui va suivre. Celle-ci est purement illustrative et doit être lue en regard des dessins annexés sur lesquels on a représenté:

- à la figure 1, déjà analysée: les moyens essentiels d'un système de radiocommunication cellulaire de type GSM;

- à la figure 2, également déjà analysée: un schéma montrant le principe connu d'un circuit amplificateur à contre réaction aval;

- à la figure 3: le spectre d'un signal multifréquence destiné à être amplifié par un dispositif selon l'invention;

- à la figure 4: le schéma d'un dispositif d'amplification selon l'invention;

- à la figure 5: un tableau dans lequel est indiqué le niveau approximatif du signal en différents noeuds du circuit du dispositif de la figure 4;

- à la figure 6: une représentation vectorielle de la tension composite du signal simplifié, pour deux conditions complémentaires concernant le niveau de la tension composite du signal à amplifier;

- à la figure 7, le schéma d'un mode de réalisation particulier, comprenant un circuit de compensation;

- à la figure 8, le schéma d'un autre mode de réalisation particulier, comprenant un amplificateur d'impulsions.

Comme il a été dit en introduction, l'amplificateur faisant l'objet de l'invention doit amplifier un signal multiporteuses, c'est-à-dire dont le spectre comprend plusieurs fréquences de porteuses dans la bande utile. Dans la suite, on parlera également d'un signal composite pour désigner un signal dont le spectre comporte plusieurs fréquences.

Dans la description qui va suivre, on considère l'exemple d'un signal occupant une largeur de bande de l'ordre de 6 ou 7 MHz.

Les porteuses sont des porteuses GSM. Parmi ces porteuses, on dénombre une porteuse balise non soumise aux sauts de fréquence et émise à un niveau constant. On dénombre également des porteuses de trafic, éventuellement soumises aux sauts de fréquence toutes les 4,6 ms et émises à des niveaux variables d'un intervalle de temps ("Time Slot") au suivant.

Plus particulièrement on considère un signal pouvant contenir sept porteuses réparties sur trente deux positions possibles dans une bande comprise entre 935,2 MHz et 940,8 MHz. Les positions possibles dans cette bande sont espacées d'un pas de 200 kHz.

A la figure 3, on a représenté le spectre d'un tel signal à un instant donné. Il comprend une porteuse balise $F_{BCCH}$ située à une position parmi huit positions possibles sur l'axe des fréquences, qui se situent de préférence en milieu MB de la bande utile. L'avantage de cette disposition sera exposé plus loin.

La position occupée par la porteuse $F_{BCCH}$ parmi les huit positions possibles ne varie pas au cours du temps, puisque cette porteuse n'est pas soumise aux sauts de fréquence. Cette position dépend de la cellule à laquelle correspond la BTS considérée au sein du motif de base du réseau cellulaire.

Le spectre du signal comporte en outre trois porteuses de trafic $F_{TCH1}$, $F_{TCH2}$, $F_{TCH3}$ pouvant respectivement occuper trois positions distinctes parmi douze positions possibles dans la partie basse BB de la bande utile.

Le spectre comporte enfin trois autres porteuses de trafic notées $F_{TCH4}$, $F_{TCH5}$, $F_{TCH6}$ pouvant respectivement occuper trois positions distinctes parmi les douze positions possibles dans la partie haute HB de la bande utile.

Ces six porteuses TCH occupent une position variable dans le temps, en fonction du saut de fréquence.

La répartition des combinaisons de porteuses est déterminée par l'opérateur et résulte des choix impliqués par la planification des fréquences disponibles. Une combinaison de fréquences telle que celle représentée à la figure 3 constitue une couleur au sens indiqué en introduction.

On notera que dans chaque couleur, on ne trouve jamais deux porteuses adjacentes c'est-à-dire espacées de 200 kHz seulement. Dit autrement, deux porteuses appartenant à une même couleur, sont espacées de 400 kHz au moins.

Le signal multifréquence dont le spectre est représenté à la figure 2, peut s'écrire sous la forme:

$$V(t) = = V.\cos(Wt+\Phi) = \Sigma\ V_i.\cos(w_it+\emptyset_i),$$

où V, W, et $\Phi$ sont respectivement le module, la pulsation et la phase du signal multifréquence exprimé sous forme vectorielle,
et où les $V_i$, $w_i$, et $\emptyset_i$ sont respectivement le module, la pulsation et la phase des signaux monofréquences associés à chacune des porteuses du spectre exprimés sous forme vectorielle.

Les modules V et Vi sont exprimés en volts. Ils sont l'indication mathématique du niveau des signaux correspondants. Pour certaines configurations des phases, le module V sera proche de $\Sigma$Vi par exemple pendant quelques dizaines de nanosecondes pour 7 porteuses 940 MHz : la tension instantanée V(t) prend alors de grandes valeurs pendant quelques dizaines de picosecondes, toutes les 500 nanosecondes, tant que V reste grand.

Les produits d'intermodulation entre les sept porteuses contenues dans le spectre utile génèrent des fréquences parasites (ou battements) dont certaines peuvent se situer dans la bande utile. Dans l'invention, on verra qu'on exploite avantageusement les fréquences de battements qui coïncident avec les sept autres positions possibles des porteuses balises pour assurer le réglage de la boucle aval du dispositif d'amplification. Il s'agira notamment de certaines des fréquences de battements du troisième ordre, du type $2 \times f_{BCCH} - f_{TCHi}$, où $f_{BCCH}$ et $f_{TCHi}$ désignent respectivement la fréquence de la porteuse $F_{BCCH}$ et celle d'une porteuse $F_{TCHi}$, avec i entier compris entre 1 et 6.

On a vu ci-dessus que les huit positions possibles des porteuses balises sont de préférence situées en milieu MB de la bande utile. L'avantage qui découle de ce choix réside dans le fait que les fréquences parasites du type ci-dessus se situent elles aussi dans le milieu MB de la bande et peuvent ainsi plus facilement coïncider avec les autres positions possibles des porteuses balises qui comme on le verra plus loin, sont facilement observables.

Un signal multiporteuses tel que celui représenté à la figure 3 est transmis dans le sens réseau fixe vers réseau mobile entre une BTS, et un ou plusieurs sites d'émission/réception où il est émis au moyen d'une antenne assurant l'interface avec l'air. Ceci est notamment le cas lorsque ces sites sont éloignés des BTS, par exemple dans une configuration microcellulaire.

Dans une telle configuration, un signal multiporteuses contenant des porteuses GSM est émis à faible puissance (0,1 Watt) par des boîtiers d'émission/réception disposés à quelques mètres au dessus du sol (on parle d'émission "au dessous des toits"), c'est-à-dire avec une portée n'excédant pas quelques centaines de mètres.

En milieu urbain, la zone de portée d'un tel signal correspond classiquement à un groupe de rues appelé "microcellule".

Plusieurs microcellules dépendent d'une même BTS et la liaison entre la BTS et les boîtiers d'émission/réception est réalisée sur fibre optique ou câble coaxial, voire même par faisceau hertzien, moyennant transposition de fréquence appropriée à chaque extrémité. Dans un exemple, la liaison entre chaque BTS et le ou les boîtiers d'émission/réception est réalisée sur câble coaxial, dans la bande comprise entre 47 et 85 MHz.

Du côté du boîtier d'émission/réception, une amplification du signal multifréquence est nécessaire, après transposition de fréquence dans la bande GSM (par exemple entre 935 et 943 MHz). Au sens de l'invention, l'équipement qui réalise cette transposition et cette amplification est appelé répéteur. Il comprend un dispositif d'amplification faisant l'objet de l'invention.

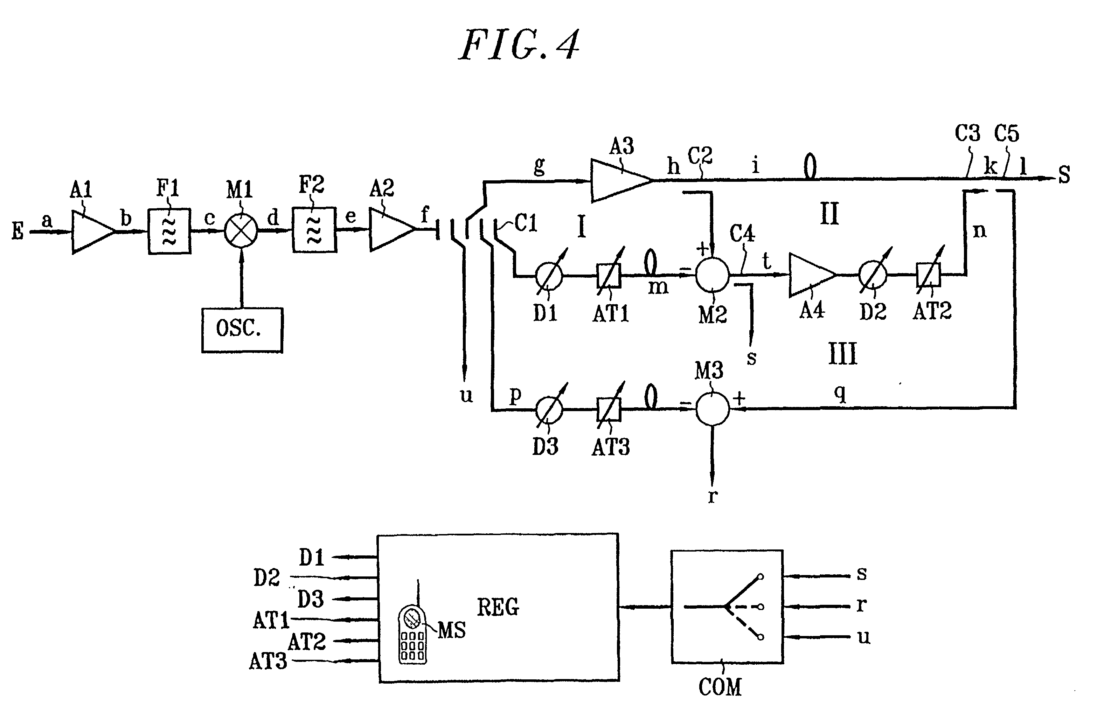

A la figure 4, on a représenté un schéma d'un dispositif d'amplification selon l'invention précédé de moyens assurant la transposition de fréquence dans la bande GSM.

Sur cette figure, les mêmes éléments qu'à la figure 3 portent les mêmes références, et les lettres minuscules a à u indiquent des noeuds du circuit du dispositif.

Les moyens assurant la transposition de fréquence dans la bande GSM sont disposés entre l'entrée E du répéteur et l'entrée du coupleur C1 du dispositif d'amplification.

Ces moyens comprennent, dans cet ordre, un premier amplificateur A1, un premier filtre F1, un mélangeur M1, un second filtre F2, un second amplificateur A2.

De plus, un oscillateur OSC, génère un signal à la fréquence de transposition dans la bande GSM, par exemple 887 MHz, qui est transmis sur une entrée adaptée du mélangeur M1 (887 + 48 = 935 MHz dans cet exemple).

Les amplificateurs A1 et A2 sont des amplificateurs aux fréquences du câble coaxial, c'est-à-dire entre 47 et 85 MHz. Le filtre F1 est soit un filtre LC soit un filtre à ondes acoustiques de surface, par exemple entre 48 et 56 MHz. Il s'agit avantageusement d'un filtre connu pour la transmission de signaux de télévision. Le filtre F2 a pour fonction d'éliminer la bande latérale inutile après transposition de fréquence en sortie du mélangeur M1.

Au noeud a, le signal est aux fréquences du câble coaxial. Au noeud f, c'est-à-dire en sortie de l'amplificateur A2, le signal est dans la bande GSM, par exemple, entre 935 et 943 MHZ.

Dans l'exemple de réalisation représenté à la figure 4, le coupleur C1 est un coupleur à quatre sorties. Une première de ces sorties est reliée à l'entrée de l'amplificateur principal A3 (noeud g). Une deuxième sortie est reliée à l'entrée du déphaseur variable D1 de la boucle amont I. La connexion des autres sorties sera expliquée plus loin.

La vérification de l'équilibre de la boucle amont I est réalisée par mesure au noeud s du niveau de tension du signal composite à la fréquence $f_{BCCH}$ de la porteuse balise $F_{BCCH}$ associée à la cellule dans laquelle se trouve le répéteur.

Dit autrement, le dispositif comprend des moyens de réglage de la boucle amont I qui sont pilotés à la fréquence de la porteuse balise $F_{BCCH}$. Ces moyens comprennent le déphaseur variable D1 et l'atténuateur variable AT1 ainsi qu'un module de régulation REG.

Le noeud s est le noeud de sortie d'un coupleur C4 disposé entre le coupleur M2 et l'entrée de l'amplificateur secondaire A4. Le coupleur C4 est un coupleur dont les pertes valent 3 dB.

Le module de régulation REG comporte un moyen de mesure du niveau de tension du signal composite à la fréquence $f_{BCCH}$ de la porteuse balise $F_{BCCH}$ associée à la cellule dans laquelle se trouve le répéteur.

Ce moyen réalise préférablement une détection synchrone avec une porteuse pure reconstituée à la fréquence $f_{BCCH}$ de la porteuse $F_{BCCH}$, de façon à produire les signaux en phase et en quadrature qui, après échantillonnage et conversion analogique numérique, sont élevées au carré et traités dans un calculateur du module de régulation REG.

A cet effet, il comprend un circuit de régénérations de la fréquence $f_{BCCH}$ de la porteuse $F_{BCCH}$.

De façon avantageuse, ce moyen de mesure est un circuit d'une station mobile du système conçu pour remplir cette fonction. On sait en effet que les stations mobiles du système de radiocommunication cellulaire comprennent de tels circuits pour détecter le niveau de la porteuse balise de la cellule dans laquelle elles se trouvent, ainsi d'ailleurs que celui des porteuses balises des autres cellules du motif de base.

Dans un exemple de réalisation particulièrement simple, une station mobile est tout simplement installée à demeure dans le répéteur pour y tenir le rôle, notamment, de circuit de régénération de la fréquence $f_{BCCH}$ de la porteuse $F_{BCCH}$ et de moyen de mesure du niveau de tension du signal composite à cette fréquence.

De plus, le réglage de la boucle amont I et celui de la boucle aval II doivent être adaptés périodiquement pour compenser la dérive en température et dans le temps des éléments qu'elles comportent.

La précision du réglage de la boucle amont I est limitée par le bruit et la présence éventuelle de fréquences parasites qui peuvent retomber à la fréquence de la porteuse balise $F_{BCCH}$.

Le dispositif selon l'invention comporte avantageusement une troisième boucle III dont la fonction est de permettre l'extraction par interférométrie des fréquences parasites résiduelles contenues dans le signal en sortie S du dispositif d'amplification, en vue du réglage de la boucle aval II. Ce signal est prélevé immédiatement en amont sortie S du circuit, à l'aide d'un coupleur C5 dont le coefficient de couplage vaut 20 dB, et est transmis sur l'entrée positive d'un coupleur M3 fonctionnant en soustracteur. L'entrée négative du soustracteur M3 reçoit le signal multifréquence à amplifier, prélevé sur une troisième sortie du coupleur C1 et transmis à travers un déphaseur variable D3 et un atténuateur variable AT3.

Dit autrement, la troisième boucle III réduit le niveau de toutes les fréquences utiles du signal délivré en sortie S du dispositif.

La mesure au noeud r qui correspond à la sortie du soustracteur M3, du niveau de tension du signal composite des fréquences parasites résiduelles qui coïncident avec la fréquence de la porteuse balise $F_{BCCH}$, permet le réglage de la boucle III de la même façon que pour la boucle amont I.

Dit autrement, le dispositif comporte des moyens de réglage de la boucle III qui sont pilotés à la fréquence de la porteuse balise $F_{BCCH}$. Ces moyens comprennent le déphaseur variable D3, l'atténuateur variable A3, et le circuit de régénération du module de régulation REG précités.

En outre, la mesure au noeud r du niveau de tension du signal composite à des fréquences parasites qui coïncident avec les fréquences des porteuses balises associées aux autres cellules du motif de base du réseau cellulaire, permet le réglage de la boucle aval II.

Dit autrement, le dispositif comporte des moyens de réglage de la boucle aval II qui sont pilotés par des observations des battements à la fréquence d'au moins une des porteuses balises associées aux cellules différentes de celle dans laquelle se trouve le répéteur. Ces moyens comprennent le déphaseur variable D2, l'atténuateur variable AT2 et le module de régulation REG précité.

En effet, le module de régulation REG comporte également des moyens de mesure du niveau du signal composite aux fréquences des sept autres porteuses balises associées aux cellules du motif de base du réseau cellulaire différentes de celle dans laquelle se trouve le répéteur.

Ces moyens réalisent une détection synchrone avec des porteuses pures reconstituées aux fréquences de ces sept porteuses.

A cet effet, ils comprennent des circuits de régénération des fréquences des sept porteuses balises précitées. Ces circuits ont la même fonction que le circuit de régénération de la fréquence $f_{BCCH}$ mentionné plus haut.

Selon une caractéristique avantageuse de l'invention, les moyens de mesure du niveau de tension du signal composite aux fréquences des porteuses balises, comprenant les huit circuits de régénération précités, sont identiques à ceux contenus dans les stations mobiles MS (figure 1) du système de radiocommunication cellulaire. En effet ces stations comprennent de tels moyens pour la mesure du niveau et de la qualité de réception des porteuses balises associées à la cellule dans laquelle elles se trouvent ainsi que des balises associées à certaines ou la totalité des autres cellules du motif de base, en vue de l'établissement du rapport de mesure transmis pour la gestion des "Hand-over".

Dans un exemple de réalisation, une station mobile est tout simplement installée à demeure dans le répéteur pour y tenir le rôle des circuits de régénération, et, de façon plus large, des moyens de mesure du niveau de tension du signal composite aux fréquences des huit porteuses balises. Dit autrement, le module de régulation REG du dispositif d'amplification comporte une station mobile MS pour y remplir cette fonction. Par conception, cette station mobile suit automatiquement les changements de fréquence des porteuses balises lors des changements du plan de fréquence.

De façon particulièrement avantageuse, le module de régulation REG est unique et est partagé dans le temps entre les trois groupes de moyens de réglage mentionnés ci-dessus. A cet effet, un sélecteur SEL reçoit sur une première entrée le signal prélevé au noeud s et sur une deuxième entrée le signal prélevé au noeud r. On peut également prévoir que ce sélecteur reçoit sur une troisième entrée le signal prélevé au noeud u, qui correspond à la quatrième sortie du coupleur C1. L'unique sortie du sélecteur SEL délivre l'un de ces trois signaux en entrée du module de régulation REG.

Ce dernier délivre en sortie, des signaux de commande du déphaseur et de l'atténuateur de chaque boucle I, II et III, à savoir, respectivement D1 et AT1, D2 et AT2, et D3 et AT3.

La dérive en température et dans le temps du gain et du déphasage des boucles est corrigée par pas élémentaires de 0,03 dB et de 1 degré respectivement.

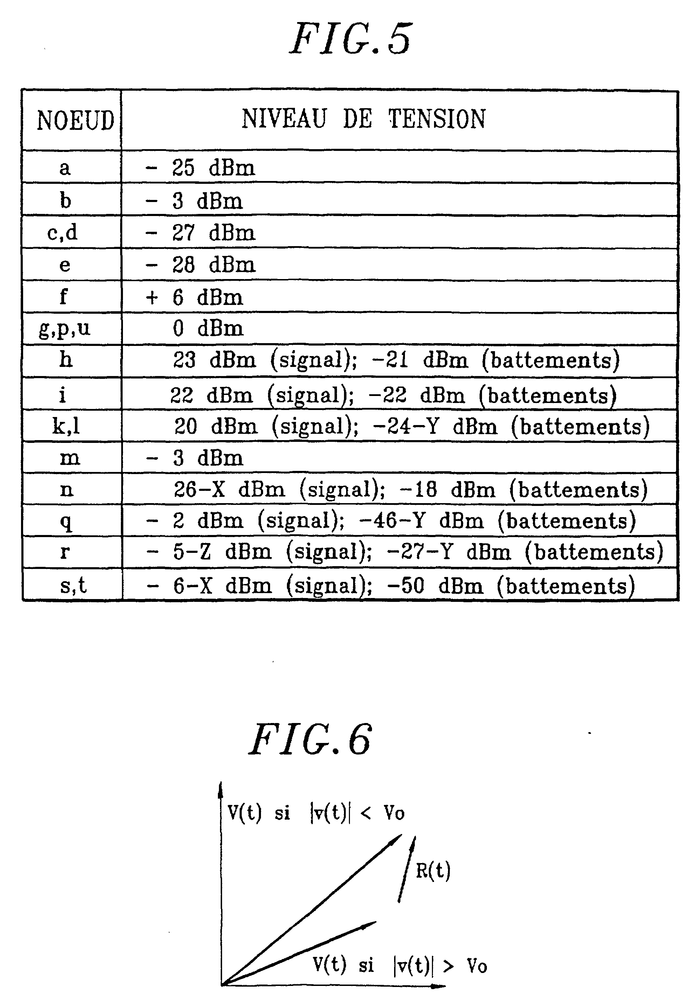

A titre d'indication, le tableau de la figure 5 donne le niveau de tension des signaux composites dans les différents noeuds du circuit référencés à la figure 4 par les lettres minuscules a à u. Ces niveaux sont exprimés en dBm. Le cas échéant, on distingue les valeurs correspondant au niveau de tension des fréquences utiles du spectre et celles correspondant à celui des battements seuls. Dans ce tableau, les lettres X, Y et Z désignent l'affaiblissement interférométrique apporté par les boucles I, II et III respectivement.

Le gain de l'amplificateur principal A3 vaut par exemple 23 dB. L'amplificateur auxiliaire A4 est un amplificateur à grand gain. Son gain vaut par exemple 32 dB. Le coupleur C2 présente un coefficient de couplage égal au gain de l'amplificateur principal A3 minoré de 3 dB. Le coupleur C3 présente approximativement 2 dB de pertes sur la ligne principale (celle allant vers la sortie S du circuit), et 6 dB de pertes sur la ligne secondaire (celle allant vers le soustracteur M3).

Selon une caractéristique avantageuse de l'invention, on exploite le fait que les porteuses sont modulées, au moins pendant un intervalle de temps déterminé, par un signal connu, et commun à toutes les porteuses. A l'intérieur de chaque intervalle de temps, il y a en effet une séquence d'apprentissage de 26 bits successifs présentant de bonnes propriétés d'autocorrélation.

Une mesure du niveau de tension du signal au noeud r, en vue du réglage de la boucle II est réalisée pendant la transmission de la séquence d'apprentissage située en milieu du train de bits émis dans chaque IT.

Selon une autre caractéristique avantageuse, plusieurs mesures du niveau de tension du signal sont réalisées pendant un même intervalle de temps ("Time Slot") de 0,577 mS, c'est-à-dire entre deux variations du niveau des porteuses de trafic. Comme il a déjà été dit, il s'agit notamment des battements du troisième ordre. De cette manière, le réglage de la boucle II peut se faire par essais successifs sur la base d'un signal à amplifier présentant un spectre constant (en fréquence et en niveau de tension).

Comme il a déjà été dit ci-dessus, les phases relatives des porteuses du signal multiporteuses à amplifier sont parfois telles que, pendant de brèves parties du temps, la tension composite du signal (c'est-à-dire la somme vectorielle des tensions correspondant à chaque porteuse du signal composite) peut atteindre des valeurs très supérieures à la valeur moyenne. Par exemple, elle pourra être supérieure de 10 dB à la valeur moyenne pendant 1% du temps. Dans ces conditions, l'amplificateur principal approche de la saturation. Il résulte que son gain est réduit, par exemple de 1 dB, et qu'il présente un retard de phase de quelques degrés. Ceci a pour conséquence de modifier l'équilibre de la boucle amont I pendant une durée très brève, typiquement quelques dizaines de nanosecondes selon la modulation des porteuses et leur espacement en fréquence.

Ce phénomène est illustré à la figure 6 où l'on a représenté le vecteur V(t) de la tension composite du signal amplifié en l'absence de dépassement d'un seuil de tension déterminé $V_o$ le module de ($|V(t)| < V_o$) et le même vecteur en cas de dépassement ($|V(t)| > V_o$).

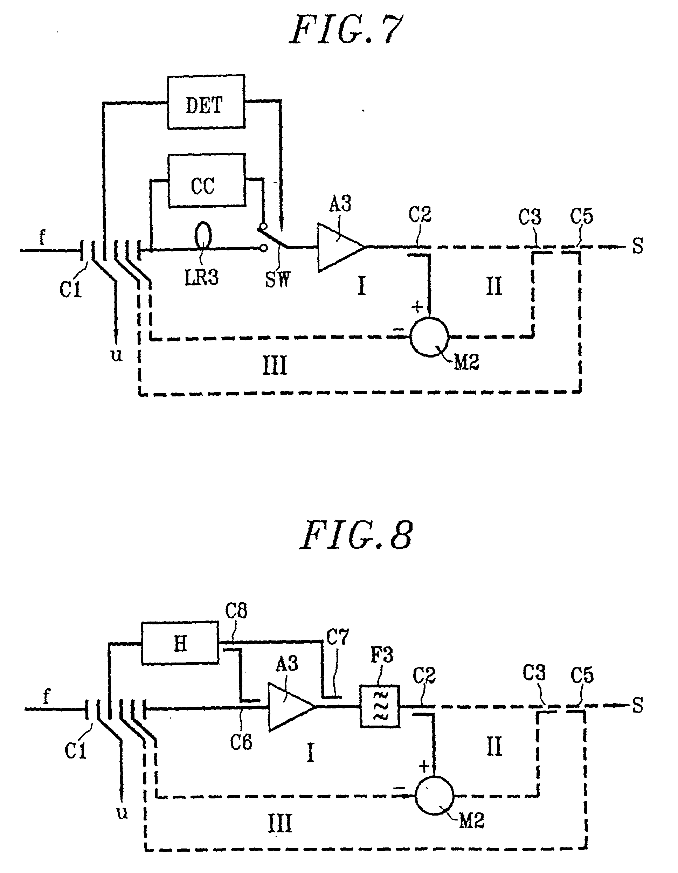

Pour pallier cet inconvénient, l'invention préconise l'emploi d'un circuit de compensation CC, disposé, en série avec un interrupteur SW à deux entrées et une sortie, entre la première sortie du coupleur C1 et l'entrée de l'amplificateur principal A3, ainsi qu'un détecteur de dépassement DET visibles à la figure 7.

Une première entrée de l'interrupteur SW est reliée à la sortie du circuit CC. La seconde entrée de l'interrupteur SW est reliée à la première sortie du coupleur C1 à travers une ligne à retard LR3. La sortie de l'interrupteur SW est reliée à l'entrée de l'amplificateur A3.

Sur cette figure, seuls les éléments du dispositif d'amplification de la figure, 4 qui sont nécessaires à la description du présent mode de réalisation ont été véritablement représentés. En particulier, les éléments non pertinents des boucles I, II, et III ne sont pas représentés, celle-ci étant symbolisées par des lignes interrompues.

Le coupleur C1 comporte une cinquième sortie pour prélever le signal à amplifier et le porter en entrée du détecteur DET.

Lorsque le module la tension composite de ce signal est inférieur au seuil $V_0$, le détecteur DET génère un signal de commande de l'interrupteur SW tel que le signal composite à amplifier est transmis directement entre la première sortie du coupleur C1 et l'entrée de l'amplificateur A3. Le circuit de compensation CC est alors inactif.

Dans le cas contraire, le détecteur DET génère un signal de commande de l'interrupteur SW tel que le signal composite à amplifier est transmis entre la première sortie du coupleur C1 et l'entrée de l'amplificateur principal A3 à travers le circuit de compensation CC. Le circuit CC est alors actif.

Le circuit de compensation CC a pour fonction d'introduire dans le signal à amplifier un signal de compensation destiné à compenser la perte de gain et le retard de phase de l'amplificateur principal A3 en cas de dépassement du seuil Vo par le module de la tension V(t).

Dit autrement, le circuit de compensation produit une tension de correction R(t) (visible à la figure 6) qui est ajouté au vecteur V(t) pour compenser la variation de ce vecteur due à la saturation de l'amplificateur A3. Il s'agit bien entendu d'une somme vectorielle.

Le circuit de compensation CC n'est actif que pendant quelques dizaines de picosecondes par nanoseconde et pendant 1% du temps globalement.

La ligne à retard LR3 insérée entre la première sortie du coupleur C1 et l'entrée de l'amplificateur A3 permet de pallier la lenteur de la commutation de l'interrupteur SW lorsqu'une situation de dépassement est détectée.

En variante, l'invention préconise l'emploi d'un amplificateur d'impulsions H, visible à la figure 8, pour pallier l'inconvénient précité dû à la saturation de l'amplificateur A3.

La simplification du schéma de la figure 8 par rapport à celui de la figure 4 appelle les mêmes remarques que celles formulées ci-dessus à l'égard de la figure 7.

Dans le mode de réalisation conforme à cette variante, le coupleur CI comporte également une cinquième sortie pour prélever le signal à amplifier et le porter en entrée de l'amplificateur d'impulsions H.

La fonction de l'amplificateur d'impulsions H est d'amplifier l'excès V(t)-V0 ou V(t)+V0 (selon le signe de V(t)) lorsque le module de V(t) est supérieur à V0. On évite ainsi la saturation de l'amplificateur A3. De cette manière, on peut en outre réduite le facteur de crête de l'amplificateur A3 et donc sa tension de sortie.

L'avantage qui en résulte est que la puissance de sortie moyenne de l'amplificateur A3 et donc sa consommation sont réduits de moitié, alors que l'amplificateur d'impulsions H ne fonctionne que 3% du temps globalement.

Le circuit impulsionnel H génère un signal de compensation qui est injecté négativement, en amont de l'amplificateur A3 dans le signal composite à amplifier, et est injecté positivement, en aval de l'amplificateur A3, dans le signal composite amplifié. Ces deux injections sont réalisées à l'aide de coupleurs respectivement C6 et C7. Le signal injecté en amont de l'amplificateur A3 par le coupleur C6 est prélevé en sortie de l'amplificateur H à l'aide d'un coupleur C8. Les coupleurs C8, C6 et C7 présentent des pertes de couplage adaptées. En fait les pertes cumulées des coupleurs C8 et C6 sont égales au gain de l'amplificateurs A3 minoré des pertes du coupleur C7 (pour des gains et des pertes exprimés en décibels).

A titre d'illustration du fonctionnement du circuit de la figure 8, on peut considérer l'exemple d'un amplificateur A3 ayant un gain égal à 20 dB, soit 10 en tension, et saturant vers 4 volts. Supposons que la valeur crête (rarement atteinte) du signal composite à amplifier V(t) soit égale à 8 volts, et que les pertes du coupleur C7 soient égales à 1/3 en tension. On fixe la valeur du seuil V0 à la valeur du facteur de crête de l'amplificateur A3, soit 4 volts. L'amplificateur d'impulsions H génère un signal de compensation Z(t) qui vaut l'écart entre la valeur crête de V(t) et le seuil V0, multiplié par le gain en tension de l'amplificateur A3 et par l'inverse des pertes en tension du coupleur C7, soit (8-4)x3=12 volts. Le niveau du signal de compensation effectivement injecté en aval de l'amplificateur A3 par le coupleur C7 est égal à 1/3x12 volts soit 4 volts. Le niveau du signal injecté négativement en amont de l'amplificateur A3 par le coupleur C6 est égal à 0,4 volts.

Ainsi, par rapport au dispositif de la figure 4, le mode de réalisation de la figure 8 consiste à remplacer l'amplificateur principal A3 par un amplificateur dont le niveau de saturation est inférieur de 3 dB, en ajoutant un amplificateur d'impulsions qui n'est actif que quelques dizaines de picosecondes par nanoseconde, et moins de 1% du temps globalement.

Un filtre passe-bande F3 disposé en aval du coupleur C7 permet de filtrer les résidus du signal de compensation qui situent à l'extérieur de la bande utile.

## Revendications

**1.** Dispositif d'amplification pour répéteur de système de radiocommunication cellulaire, notamment un système GSM 900 ou DCS 1800, destiné à l'amplification d'un signal multiporteuses transmis dans le sens réseau fixe vers réseau mobile et ayant un spectre qui comprend une porteuse balise ($F_{BCCH}$) dont la fréquence est fixe et est associée à la cellule dans laquelle se trouve le répéteur, et au moins une porteuse de trafic ($F_{TCH1}$-$F_{TCH6}$) soumise à un saut lent de fréquence, caractérisé en ce qu'il comporte :

- un amplificateur principal (A3);
- un dispositif à contre réaction aval comprenant une boucle amont (I) pour extraire par interférométrie les composantes du signal amplifié qui correspondent à des fréquences parasites, et une boucle aval (II) pour annuler par interférométrie lesdites composantes dans le signal amplifié;
- des moyens (D1,AT1,REG) de réglage de la boucle amont (I) qui sont pilotés à la fréquence de la porteuse balise ($F_{BCCH}$).

**2.** Dispositif d'amplification selon la revendication 1, caractérisé en ce que le dispositif à contre réaction aval comporte en outre une troisième boucle (III) pour extraire par interférométrie les fréquences parasites résiduelles du signal en sortie du dispositif d'amplification.

**3.** Dispositif d'amplification selon la revendication 2, caractérisé en ce qu'il comporte des moyens (D3,AT3,REG) de réglage de la troisième boucle qui sont pilotés à la fréquence de la porteuse balise ($F_{BCCH}$).

**4.** Dispositif d'amplification selon la revendication 2, caractérisé en ce qu'il comporte des moyens (D2,AT2,REG) de réglage de la deuxième boucle (II) pilotés à la fréquence d'au moins une des porteuses balises associées aux cellules différentes de celle dans laquelle se trouve le répéteur.

**5.** Dispositif d'amplification selon l'une des revendications précédentes, caractérisé en ce que les moyens de réglage de la boucle amont (I), ceux de la boucle aval (II) et ceux de la troisième boucle (III) comprennent des moyens de mesure des signaux aux fréquences des porteuses balises.

**6.** Dispositif d'amplification selon la revendication 5, caractérisé en ce que lesdits moyens de mesure sont identiques à ceux contenus dans les station mobiles du système.

**7.** Dispositif d'amplification selon la revendication 6, caractérisé en ce qu'il comporte une station mobile installée à demeure pour tenir le rôle des moyens de mesure des signaux aux fréquences des porteuses balises.

**8.** Dispositif d'amplification selon l'une des revendications précédentes, caractérisé en ce qu'il comporte un circuit de compensation pour compenser la perte de gain et de retard de phase dans la boucle amont (I) du dispositif à contre réaction aval lorsque le niveau du signal amplifié dépasse un seuil déterminé.

9. Dispositif d'amplification selon l'une des revendications précédentes, caractérisé en ce qu'il comporte, en parallèle sur l'amplificateur principal, un amplificateur impulsionnel fonctionnant lorsque le niveau du signal dépasse un seuil déterminé.

10. Procédé pour la mise en oeuvre d'un dispositif d'amplification selon l'une quelconques des revendications 4 à 9, caractérisé en ce qu'au moins une mesure du niveau du signal à la fréquence d'une des porteuses balises autres que celle de la cellule dans laquelle se trouve le répéteur, est réalisée pendant la transmission de la séquence d'apprentissage située en milieu du train de bits émis dans chaque intervalle de temps.

11. Procédé selon la revendication 10, caractérisé en ce que plusieurs mesures sont réalisées pendant un même intervalle de temps.

**Patentansprüche**

1. Verstärkervorrichtung für einen Verstärker eines zellularen Funkkommunikationssystems, insbesondere eines GSM 900 - oder DCS 1800 - Systems, zur Verstärkung eines von einem ortsfesten Netz in Richtung eines mobilen Netzes übertragenen Signals mit mehreren Trägern und einem Spektrum, das einen Kennungsträger ($F_{BCCH}$), dessen Frequenz fest und der Zelle zugeordnet ist, in der sich der Verstärker befindet, und mindestens einen Sprechverkehrsträger ($F_{TCH1}$-$F_{TCH6}$) aufweist, der einem langsamen Frequenzsprung unterliegt, dadurch gekennzeichnet, daß sie aufweist:

   - einen Hauptverstärker (A3);
   - eine Mitkopplungs-Vorrichtung mit einer vorgeschalteten Schleife (I), um die Störfrequenzen entsprechenden Komponenten des verstärkten Signals durch Interferometrie zu extrahieren, und einer nachgeschalteten Schleife (II), um diese Komponenten im verstärkten Signal durch Interferometrie zu unterdrücken;
   - Einrichtungen (D1, AT1, REG) zur Regelung der vorgeschalteten Schleife (I), die mit der Frequenz des Kennungsträgers ($F_{BCCH}$) gesteuert werden.

2. Verstärkervorrichtung nach Anspruch 1, dadurch gekennzeichnet, daß die Mitkopplungs-Vorrichtung außerdem eine dritte Schleife (III) aufweist, um die restlichen Störfrequenzen des Signals am Ausgang der Verstärkervorrichtung durch Interferometrie zu extrahieren.

3. Verstärkervorrichtung nach Anspruch 2, dadurch gekennzeichnet, daß sie Einrichtungen (D3, AT3, REG) zur Regelung der dritten Schleife aufweist, die mit der Frequenz des Kennungsträgers ($F_{BCCH}$) gesteuert werden.

4. Verstärkervorrichtung nach Anspruch 2, dadurch gekennzeichnet, daß sie Einrichtungen (D2, AT2, REG) zur Regelung der zweiten Schleife (II) aufweist, die mit der Frequenz mindestens eines der Kennungsträger ($F_{BCCH}$) gesteuert werden, die den anderen Zellen als der Zelle zugeordnet sind, in der sich der Verstärker befindet.

5. Verstärkervorrichtung nach einem der vorhergehenden Ansprüche, dadurch gekennzeichnet, daß die Einrichtungen zur Regelung der vorgeschalteten Schleife (I), der nachgeschalteten Schleife (II) und der dritten Schleife (III) Einrichtungen zur Messung der Signale mit den Frequenzen der Kennungsträger aufweisen.

6. Verstärkervorrichtung nach Anspruch 5, dadurch gekennzeichnet, daß die Meßeinrichtungen denen gleichen, die in den mobilen Stationen des Systems enthalten sind.

7. Verstärkervorrichtung nach Anspruch 6, dadurch gekennzeichnet, daß sie eine mobile Station aufweist, die dauerhaft installiert ist, um die Aufgabe der Einrichtungen zur Messung der Signale mit den Frequenzen der Kennungsträger zu erfüllen.

8. Verstärkervorrichtung nach einem der vorhergehenden Ansprüche, dadurch gekennzeichnet, daß sie eine Kompensationsschaltung aufweist, um den Verstärkungsverlust und die Phasenverzögerung in der vorgeschalteten Schleife (I) der Mitkopplungs-Vorrichtung zu kompensieren, wenn der Pegel des verstärkten Signals einen bestimmten Schwellwert übersteigt.

9. Verstärkervorrichtung nach einem der vorhergehenden Ansprüche, dadurch gekennzeichnet, daß sie parallel zum Hauptverstärker einen Impulsverstärker aufweist, der arbeitet, wenn der Pegel des Signals einen bestimmten Schwellwert überschreitet.

10. Verfahren zur Anwendung einer Verstärkervorrichtung nach einem der Ansprüche 4 bis 9, dadurch gekennzeichnet, daß mindestens eine Messung des Pegels des Signals mit der Frequenz eines anderen Kennungsträgers als dem der Zelle, in der sich der Verstärker befindet, während der Übertragung der Lernsequenz durchgeführt wird, die sich in der Mitte der Bitfolge befindet, die in jedem Zeitintervall ausgesendet wird.

**11.** Verfahren nach Anspruch 10, dadurch gekennzeichnet, daß mehrere Messungen während eines gleichen Zeitintervalls durchgeführt werden.

## Claims

**1.** Amplification device for a repeater in a cellular radio communication system, in particular a GSM 900 or DCS 1800 system, intended for amplifying a multicarrier signal transmitted in the direction from fixed network to mobile network and having a spectrum which comprises a beacon carrier ($F_{BCCH}$) whose frequency is fixed and is associated with the cell in which the repeater is situated, and at least one traffic carrier ($F_{TCH1}$-$F_{TCH6}$) subjected to slow frequency hopping, characterised in that it includes:

  - a main amplifier (A3);

  - a downstream feedback device comprising an upstream loop (I) for extracting by interferometry the components of the amplified signal which correspond to parasitic frequencies, and a downstream loop (II) for cancelling out by interferometry the said components in the amplified signal;

  - means (D1, AT1, REG) for regulating the upstream loop (I) which are controlled at the frequency of the beacon carrier ($F_{BCCH}$).

**2.** Amplification device according to Claim 1, characterised in that the downstream feedback device also has a third loop (III) for extracting by interferometry the residual parasitic frequencies of the signal output from the amplification device.

**3.** Amplification device according to Claim 2, characterised in that it has means (D3, AT3, REG) of regulating the third loop which are controlled at the frequency of the beacon carrier ($F_{BCCH}$).

**4.** Amplification device according to Claim 2, characterised in that it has means (D2, AT2, REG) of regulating the second loop (II) controlled at the frequency of at least one of the beacon carriers associated with the cells different from the one in which the repeater is situated.

**5.** Amplification device according to one of the preceding claims, characterised in that the regulation means for the upstream loop (I), those for the downstream loop (II) and those for the third loop (III) comprise means of measuring the signals at the frequencies of the beacon carriers.

**6.** Amplification device according to Claim 5, characterised in that said measuring means are identical to those contained in the mobile stations in the system.

**7.** Amplification device according to Claim 6, characterised in that it has a mobile station permanently installed to fulfil the role of the means of measuring the signals at the frequencies of the beacon carriers.

**8.** Amplification device according to one of the preceding claims, characterised in that it has a compensation circuit for compensating for the loss of gain and phase delay in the upstream loop (I) of the downstream feedback device when the level of the amplified signal exceeds a given threshold.

**9.** Amplification device according to one of the preceding claims, characterised in that it has, in parallel to the main amplifier, a pulse-type amplifier functioning when the signal level exceeds a given threshold.

**10.** Method for using an amplification device according to any one of Claims 4 to 9, characterised in that at least one measurement of the level of the signal at the frequency of one of the beacon carriers other than the one in the cell in which the repeater is situated is carried out during the transmission of the learning sequence situated in the middle of the bit stream sent in each interval of time.

**11.** Method according to Claim 10, characterised in that several measurements are made during the same interval of time.

*FIG. 1*

EP 0 971 478 B1

## FIG.2

## FIG.3

14

# FIG.4

EP 0 971 478 B1

## FIG.5

| NOEUD | NIVEAU DE TENSION |
|---|---|
| a | − 25 dBm |
| b | − 3 dBm |
| c,d | − 27 dBm |
| e | − 28 dBm |
| f | + 6 dBm |
| g,p,u | 0 dBm |
| h | 23 dBm (signal); −21 dBm (battements) |
| i | 22 dBm (signal); −22 dBm (battements) |
| k,l | 20 dBm (signal); −24−Y dBm (battements) |
| m | − 3 dBm |
| n | 26−X dBm (signal); −18 dBm (battements) |
| q | − 2 dBm (signal); −46−Y dBm (battements) |
| r | − 5−Z dBm (signal); −27−Y dBm (battements) |
| s,t | − 6−X dBm (signal); −50 dBm (battements) |

## FIG.6

$V(t)$ si $|v(t)| < V_0$

$R(t)$

$V(t)$ si $|v(t)| > V_0$

## *FIG.7*

## *FIG.8*